# EUROPEAN PATENT SPECIFICATION

(11) **EP 0 809 596 B1**
(45) Date of publication and mention of the grant of the patent: **21.11.2001**
(21) Application number: 96903264.8
(22) Date of filing: 24.02.1996
(51) Int. Cl.: B65G 51/03, H01L 21/00, H01L 21/68

(54) **METHOD AND APPARATUS FOR TRANSPORTING LEAD FRAME, AND IN-LINE SYSTEM USING THEM**
VERFAHREN UND VORRICHTUNG ZUM TRANSPORTIEREN VON LEITERRAHMEN UND IN-LINE SYSTEM DAFÜR
PROCEDE ET APPAREIL POUR LE TRANSPORT D'UNE GRILLE DE CONNEXION, ET SYSTEME EN LIGNE LES METTANT EN UVRE

(30) Priority: 28.02.1995 KR 9504187
(43) Date of publication of application: 03.12.1997
(73) Proprietor: SAMSUNG ELECTRONICS CO., LTD., Suwon-City, Kyungki-do (KR)
(72) Inventor: PARK, Bok, Sik, Suwon-city Kyunggi-do 442-060 (KR); CHO, Sung, Hee, Chungcheongnam-do 330-070 (KR); KIM, Deog, Gyu, Chungcheongnam-do 330-070 (KR); LEE, Yong, Choul 101-1104, Daewoo Tower Apartment, Chungcheongnam-do 330-090 (KR)
(74) Representative: Sparing - Röhl - Henseler Patentanwälte
(86) International application number: PCT/KR96/00028
(87) International publication number: WO 96/26875

(56) References cited:
- DE-A- 3 120 696
- US-A- 4 749 329
- US-A- 4 978 253

## Description

### BACKGROUND OF THE INVENTION

### 1. FIELD OF THE INVENTION

The present invention is generally related to a method and apparatus for transporting lead frames, and to an in-line system using the same.

### 2. DESCRIPTION OF THE RELATED ARTS

Usually, the semiconductor chip assembly process begins with die bonding process in which an individual chip ("die") separated from silicon wafer consisting of a plurality of integrated circuit elements is attached to a lead frame. Lead frame is a plate having leads for electrically connecting the chip to external electrical elements, and is made of copper alloys or iron-nickle alloys. It also supports the chip during the whole assembly process. The lead frame onto which the chip is attached is electrically coupled to the chip through wires or by bonding directly parts ("inner leads") thereof to the metal pads of the chip.

Then, the chip semi-assembly is encapsulated to provide a protection from environmental effects such as moisture, dust, or physical and electrical shocks. Thus an obtained package is then subjected to cutting/forming process to cut and form the leads to be adapted to the mounting on the circuit board. The package is then subjected to various electrical and reliability tests, and the passed packages are supplied to the consumers.

As described above, the semiconductor package assembly process is consisted of many steps, and the capacity of each step is different from each other. Therefore, carrying out continuously each step is very difficult. For example, four chips can be attached to die pads of four lead frames in the die bonding process while only one chip can be electrically connected to the lead frame in the wire bonding process for the same period of time. Moreover, for the LOC(Lead On Chip) package assembly process, it requires approximately 0.8 - 2.0 seconds to bond the chip to the die pad with a polyimide tape by applying heat and pressure thereon, which is about half the time required for the subsequent wire bonding process. To solve the problems in association with such differences between the required time in each steps and to improve the productivity of the package assembly process, an integration system called in-line system has been proposed, in which one die bonding apparatus is coupled with more than two wire bonding apparatuses. Such in-line system is particularly advantageous for the large scale assembly and production factories such as memory element production factories.

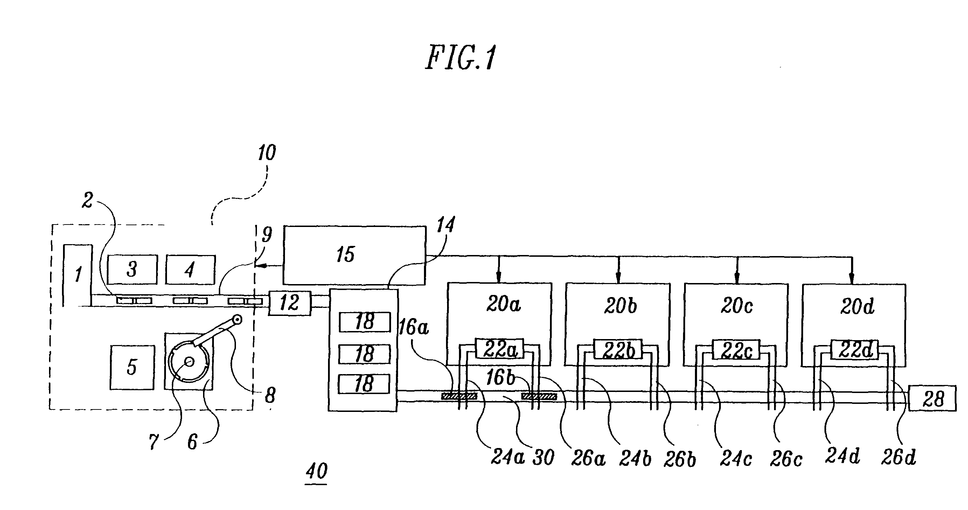

FIG.1 is a schematic diagram of an in-line system. The system (40) comprises one die bonding apparatus (10), four wire bonding apparatuses (20a, 20b, 20c, 20d) and a transport apparatus (30) for transporting the lead frame (16).

Each of a plurality of lead frames in the stocker (not shown) is fed into a working rail (9) by lead frame separator (1). Lead frames (2) on the rail (9) have lead patterns to be electrically connected to the electrical pads of the chip, said patterns being connected to each other through a side rail, forming a strip. The wafer cassette (5) contains wafers having integrated circuit elements and had already been subjected to back lapping, scribing and back tape attaching. When a wafer (not shown) is mounted on xy-table (6), chip separator (7) separates individual chips from the wafer, said separated chips are then transported to the die bonding head (4) by chip transport module (8). The die pad (not shown) of the lead frame (2) at the rail (9) beneath the bonding head (4) is supplied with dots of an adhesive such as Ag-epoxy. For the case where the chip is directly attached to the lead of the lead frame without a die pad, for example LOC packages, the dotting of the adhesive is not required.

The bonding head (4) aligns the the lead frame and the chip at an appropriate position, where they will be attached together, and presses them under heat and pressure to bond them together.

The lead frame onto which a chip is attached by die bonding apparatus (10) is then moved into prebake chamber (12) where the adhesive will be cured at a predetermined temperature and time.

Buffer (14) is composed of a plurality of inlet magazines (18) where the lead frames, which are transported after the completion of die bonding, are stacked before they are transported to the wire bonding stage. The reason that a plurality of magazines is used to feed lead frames into wire bonding stage is that, first, even if the die bonding apparatus (10) does not work, lead frames can be continuously fed into the wire bonding stage. Second, when the die bonding apparatus (10) cannot output sufficient die bonded lead frames, the lead frames that are die bonded by a separate ex-line die bonding apparatus are fed into buffer (14) in order continuously to carry out wire bonding. Lead frame (16a) having a chip attached thereto, which is transported to lead frame transport module (30) from inlet magazines (18), is undergone wire bonding by one of four wire bonding apparatuses (20a through 20d).

Wire bonding apparatus (20) is composed of loader (24), unloader (26) and wire bonding head (22). Wire bonded lead frame (16) is transported by transport module (30) to outlet magazines (28), from which the lead frame will be transferred to the subsequent assembly step such as molding. Outlet magazines (28) have the same structure as that of inlet magazines (18) of buffer (14).

Control part (15)controls the transport of the lead frame and the overall operation of the system, and is a microprocessor. Its initial operational values are determined by the size and shape of the lead frame we well by the structure of the chip.

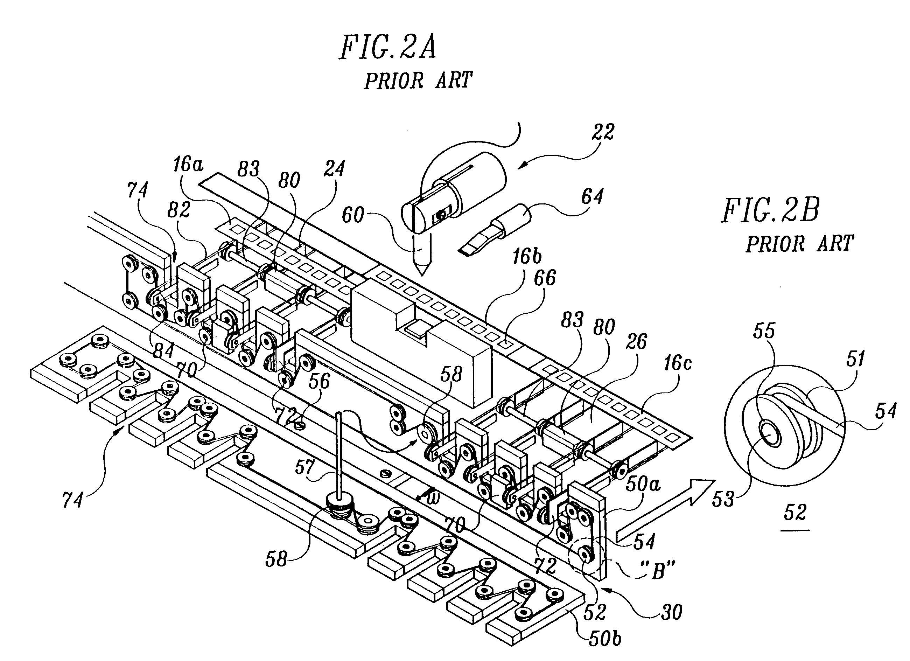

Lead frame transport module (30) in such an in-line system employs conveyor belts for transporting the lead frame as shown in FIG. 2A. Lead frame transport module (30) is composed of two rail bodies; first (50a) and second (50b) rail bodies, which have the same structure. Rail body (50) has a large number of rollers (52), onto which belts (54) are wound. First rail body (50a) is interconnected to second rail body (50b) by connector board (56). The width (W) of board (56) is adjusted depending on the width of lead frame (16) to be transported. The power for moving the conveyor belt is supplied by a motor, which is between first rail body (50a) and wire bonding head (22), although not shown in FIG. 2A. The moving of the motor is transferred to power transfer shaft (57), one end of which is coupled to power transfer roller (58) of first rail body, while the other end thereof is coupled to power transfer roller (58) of second rail body, thereby making it possible to control the moving speed of conveyor belts (54) of first rail body to be the same as that of second rail body. Side rail of lead frame is in contact with conveyor belt (54), and moves upon the moving of conveyor belt (54) by the power from the motor.

US-A-4,978,253 describes an air cushion conveying device with a magnetic guidance device having a rail provided with air vents, permitting the longitudinal displacement of a wafer supporting disk without contact to the rail. The wafer supporting disk is provided with a magnetic device on its bottom that corresponds to a magnetic guidance device on the upper face of the rail. This continually working air cushion device possesses fixed stop means at the end of a rail, by orifices in the form of a circle, that are incorporated into the air supply of the rail and furthermore, by two magnetized inserts that brings about the stoppage of the wafer supporting disk. This stop means has to be placed always at the end of the rail, because the wafer supporting disk can not alternatively be transported across this stop means.

When lead frame (16) reaches a certain predetermined position of rail (50), sensor (70) detects it and transfers the detected signal to stopper (72). The " 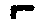 "-shaped stopper (72) is hidden within split (74) formed in rail body (50) when lead frame passes, and is projected outside the split when it is received a signal from sensor (70) to stop the lead frame. The moving lead frame stops when it collides stopper (72). Since the moving/stop of lead frame is controlled by the control part of the in-line system (for example, controller (15) in FIG. 1), the motor can be controlled to stop conveyor belt (54) and consequently lead frame. Nevertheless, in such case, since lead frame is leaned toward its traveling direction by action of inertia, stopper (72) should be employed in order accurately to control the stop of the lead frame at a proper position.

Detection of the position of lead frame is required when a lead frame arrives at loader (24) and unloader (26) of a certain wire bonding apparatus among a plurality of wire bonding apparatus. FIG. 2A shows a state in which die bonded lead frame (16a) is moved to wire bonding apparatus from rail (50) by loader (24) of wire bonding apparatus, and wire bonded lead frame (16c), which is placed on unloader (26), stands ready for return to rail (50).

Since loader (24) and unloader (26) have the same structure and operation, only loader (24) in FIG. 2A will be described. Loader (24) employs a belt for transporting lead frame. Thus, loader and unloader are composed of belt (82), roller (84), onto which belt is wound, and motor (80) supplying power to belt. Belt wound onto the roller, which is on rail (50), is hidden in split (74) formed in rail (50) during the transport of lead frame. When sensor (70) detects the position of the lead frame and the lead frame stops by stopper (72), belt (82) hidden in the split and roller (84) are moved upward above shaft (83), and lead frame (16a) is transported to wire bonding apparatus according to the movement of belt (82) of loader.

Bonding head (22) of wire bonding apparatus is composed of capillary (60), into which gold or aluminum wire (62) is fed, and trimmer (64) for cutting wire after the completion of wire bonding between lead of lead frame and metal pad of the chip. After completion of wire bonding of every individual chip (66) attached to lead frame (16b), lead frame is moved to unloader (26) where lead frame is moved to rail by movement of belt of unloader (26).

The above-described lead frame transport module (30) of conveyor belt type has problems in association with a use of many rollers (52) (for example, 400 rollers) and belts (for example, 16 belts), for example abrasions of parts thereof due to mechanical frictions therebetween. That is to say, as shown in FIG. 2B, the individual roller (52) is composed of pivotal shaft (53), bush (55) and bearing (51), which will be abraded during the rotations of the roller and should be replaced. Moreover, dusts generated during the abrasions are critical contaminants, which cause significant semiconductor failures. Further, even if only one part is ran out, the whole system should be stopped to replace the worn part, resulting in the reduction of the productivity and the increase in the production cost.

Such problems are not limited to in-line system, but are common to all the apparatus employing conveyor belt for transport.

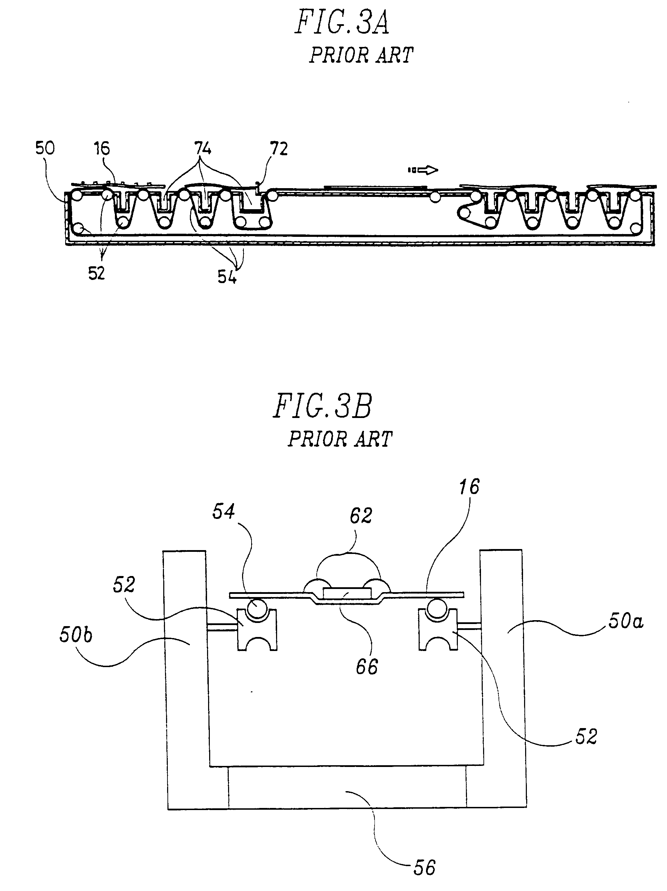

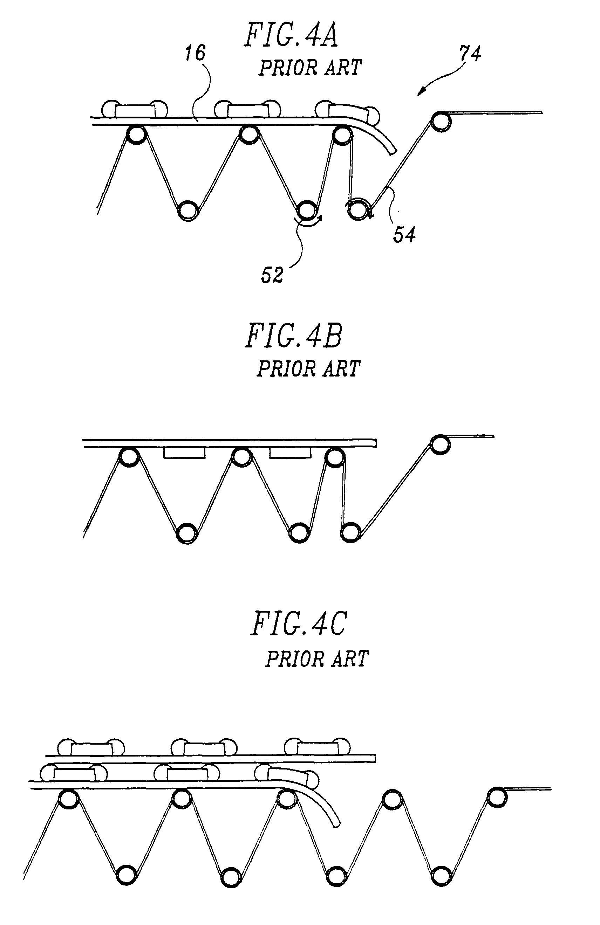

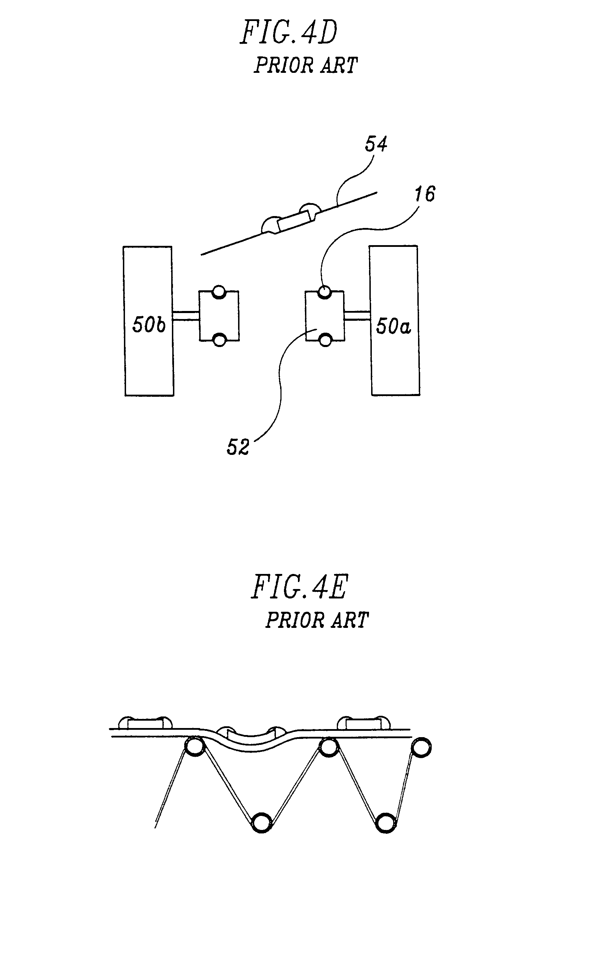

Besides, the conveyor belt type transport systems also have another problems associated with the unstability of the transport rails, which will be described with reference to FIGs. 3 and 4.

FIGs. 3A and 3B are sectional views showing the transport of the lead frame using the conventional transport having conveyor belt. In order to simplify drawings, the sensor, motor and power transferring parts are omitted. As belt (54) moves in the direction indicated by arrow, lead frame (16) in contact with belt through its side rail moves accordingly. Although FIG. 3B shows wire bonding of chip (66) to lead frame (16) through wire (62), if it shows lead frame fed into loader (24 in FIG. 2) of wire bonding apparatus, the lead frame is just die-bonded.

By the way, as described above, since the surface of belt (54) is not peripheral to the moving direction of the lead frame and belt (54) passes through split (74) of lead frame stopper (72) or loader/unloader of wire bonding apparatus, many parts of belt (54) cannot be contacted with side rail of lead frame. Further, since each roller (52) is at different heights and belt (54) droops due to tension, lead frame (16) moves on uneven surfaces of belt (54).

In particular, lead frame (16) passing the vicinity of split (74) is apt to be curled into between belt (54) and roller (52), causing a failure, as can be seen from FIG. 4A.

The difference between the moving speeds or heights of rails (50a, 50b) may cause a reversion of lead frames (see FIG. 4B), overlapping of two lead frames (see FIG. 4C), or in the worst case, cause a swerve or derailment of lead frame from rail (see FIG. 4D).

Moreover, since the lead frame moves with waves, for the case of very thin lead frame, for example TOSP (Thin Small Outline Package), the bonded wires' sagging is so large that they may be contacted with chip or broken during the transport of lead frame (see FIG. 4E). According to the observation of the inventors, thin lead frame with less than 6 mil thickness cannot be transported using the conveyor belt type system.

If LOC (Lead On Chip) packages having a chip attached to the lower surface of lead frame are applied to the conveyor belt type transport system, they may be damaged due to the contact of the chip to the belt, and consequently they cannot be applied to the conveyor belt type transport system.

### SUMMARY OF THE INVENTION

Thus, an object of the invention is to provide an improved lead frame transport method and apparatus, which are free from the above described problems associated with the conventional transport apparatus.

Another object of the invention is to increase productivity of the semiconductor assembly process while reducing the production cost by preventing mechanical abrasion of the lead frame transport apparatus.

The other object of the invention is to reduce failures of packages while increasing the productivity by improving clearness of working place of semiconductor package assembly.

The other object of the invention is to prevent various failures during the lead frame transport in semiconductor package assembly system.

The still other object of the invention is to transport very thin lead frames for TSOP efficiently.

The other object of the invention is to provide a stable transport of lead frame in LOC package assembly.

The other object of the invention is to increase working efficiency of in-line lead frame transport system by stably transport lead frame as well as by increasing the transport speed.

This object can be accomplished by an improved lead frame transport apparatus and method, which comprises a floating and stable transport of lead frame by blowing air at a certain degree into lead frame transport rail.

### BRIEF DESCRIPTION OF THE DRAWINGS

These and various other features and advantages of the present invention will be readily understood with reference to the following detailed description taken in conjunction with the accompanying drawings, wherein like reference numerals designate like structural elements, and, in which:
FIG. 1 is a schematic diagram showing an in-line system adapting a die bonding apparatus in integration with a plurality of wire bonding apparatus;
FIG. 2A is a cut away perspective view of lead frame transport apparatus employing the conventional conveyor belt;
FIG. 2B is an enlarged view of roller employed in the conventional lead frame transport apparatus;
FIGs. 3A and 3B are front and side views showing the steps of transporting lead frame by using the conventional conveyor belt, respectively;
FIG. 4A shows a winding of a lead frame into roller of the conventional lead frame transport apparatus during its operation;
FIG. 4B shows a reversal of lead frame during transfer thereof by using the conventional lead frame transport apparatus;
FIG. 4C shows an overlapping of lead frames during transfer thereof by using the conventional lead frame transport apparatus;
FIG. 4D shows a derailment of lead frame during transport thereof by using the conventional lead frame transport apparatus;
FIG. 4E shows an undulation of a strip of the lead frame during transport thereof by using the conventional lead frame transport apparatus;
FIGs. 5A and 5B are cut-away partial perspective view and partial enlarged view of the lead frame transport apparatus according to the present invention, respectively;
FIGs. 6A and 6B are sectional and enlarged partial views showing the steps of transporting lead frame according to the inventive method using air feeding mechanism, respectively;
FIG. 7 is a block diagram showing the control of moving/stop of the lead frame by using the conventional in-line system employing the conveyor belt;
FIG. 8 is a block diagram showing the control of moving/stop of the lead frame by using the inventive in-line system employing the air feeding mechanism;
FIGs. 9A and 9B are schematic and enlarged partial views showing the supply of air by using a solenoid control mechanism as an example of air rail controller according to the present invention;
FIG. 10 is a schematic perspective view of the die bonding apparatus in the in-line system according to the present invention;
FIG. 11 is a schematic diagram of steps of separating the lead frame by using a lead frame separator of the die bonding apparatus in the in-line system according to the present invention;
FIGs. 12A and 12B are schematic sectional views of separating the semiconductor chip by using a two-step chip separator of the die bonding apparatus in the in-line system according to the present invention;
FIG. 13 is a plan view of lead frame, which shows the steps of trimming/forming of semiconductor chip package;
FIG. 14 is a schematic view of the in-line trimming/forming apparatus employing the air transferring mechanism according to the present invention; and
FIG. 15 is a partial perspective view of the guide rail of the in-line trimming/forming apparatus employing the air transporting mechanism according to the present invention.

### DETAILED DESCRIPTION OF THE INVENTION

The present invention will now be described in more detail with reference to accompanying drawings.

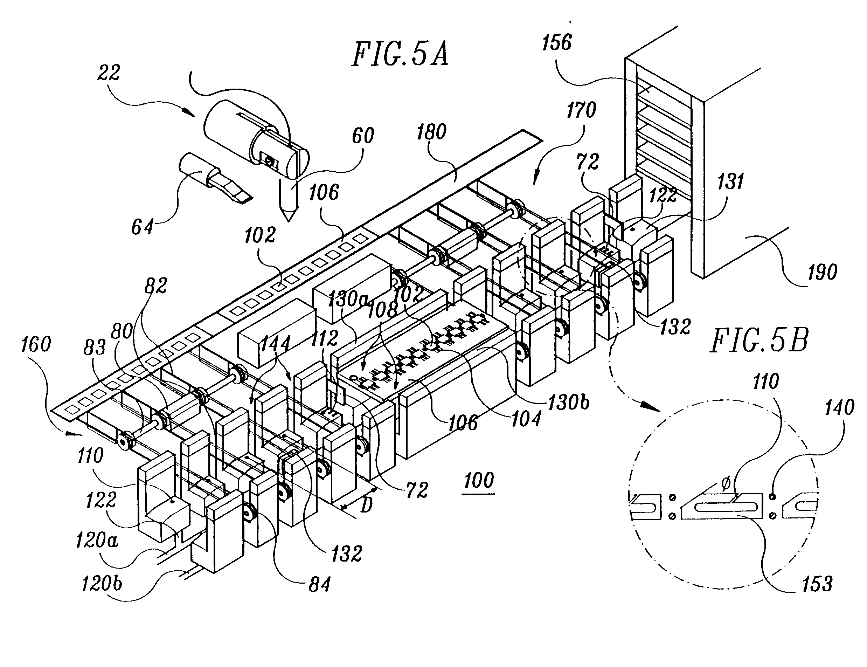

FIG. 5A is a partial cut away perspective view of lead frame transport apparatus according to the present invention. The lead frame transport apparatus according to the present invention (100) does not have conveyor belt, roller and motor, which are employed for the conventional lead frame transport apparatus. Instead, a pressed air supplied through air duct (120, 122) is used as driving power for moving lead frame. That it to say, the lead frame can be moved on air rail (130) by the action of the air supplied through air vent holes (110) formed within said rail (130) at an angle of certain degrees with respect to horizontal plane (131) of rail (130). In order to move both side rails (108) of lead frame (106) by the action of air, a pair of air rails, i.e., first air rail (130a) and second air rail (130b) are formed. Air vent holes (110) are preferably uniformly spaced so that a uniform force can be applied to the lead frame. In FIG. 5, loading/unloading belt (140) and roller (142) for loading/unloading lead frame into/from an assembly part, for example wire bonding apparatus, are formed at split (144). The loading/unloading belt may be anyone employed in the conventional conveyor belt type transport system.

Air rail (130) comprises many sub-rails (153) as shown in FIG. 5B. Sub-rails (153) have preferably the identical size and shape, since the distance between every of the air vent holes (110) in sub-rails (153) can be constant, consequently the power applied to lead frame through air vent holes (110) can be uniform throughout the rail (130). The front top edge of Sub-rails (153) has a slant surface, the slope of which has an angle of θ in order to prevent the lead frame from being caught by the next sub-rail when lead frame passes between sub-rails.

Lead frame can be stopped by quitting the supply of air through air duct (120) as well as applying vacuum through vacuum hole (112), when sensor (132) detects that lead frame moving along above rail (130) arrives the stop position. The stop position may be loading part (160) of wire bonding apparatus, when the lead frame should be wire bonded. In addition to vacuum hole (112), stopper (72), which is employed for the conventional conveyor belt type transport system, can be also used to stop lead frame. For this case, vacuum hole (112) has a role to reduce the impact on the lead frame when the lead frame collides stopper (72).

Lead frame is transferred to rail (180) of wire bonding apparatus and then moved to bonding head (22), when loading belt (82) and roller (84), which are in split (144) of rails (130), are lifted above shaft (83) and belt (82) moves by motor (80). Lead frame (106) is electrically connected to chip (102) through wires by bonding head (22). After completion of wire bonding, lead frame moves along rail (180) to unloading part (170), and then loaded onto air rail (130) by unloading belt. In this manner, wire bonded lead frame (156) is stacked into magazine (190) and then transported to the subsequent assembly processes, for example molding process to be encapsulated to form a package body.

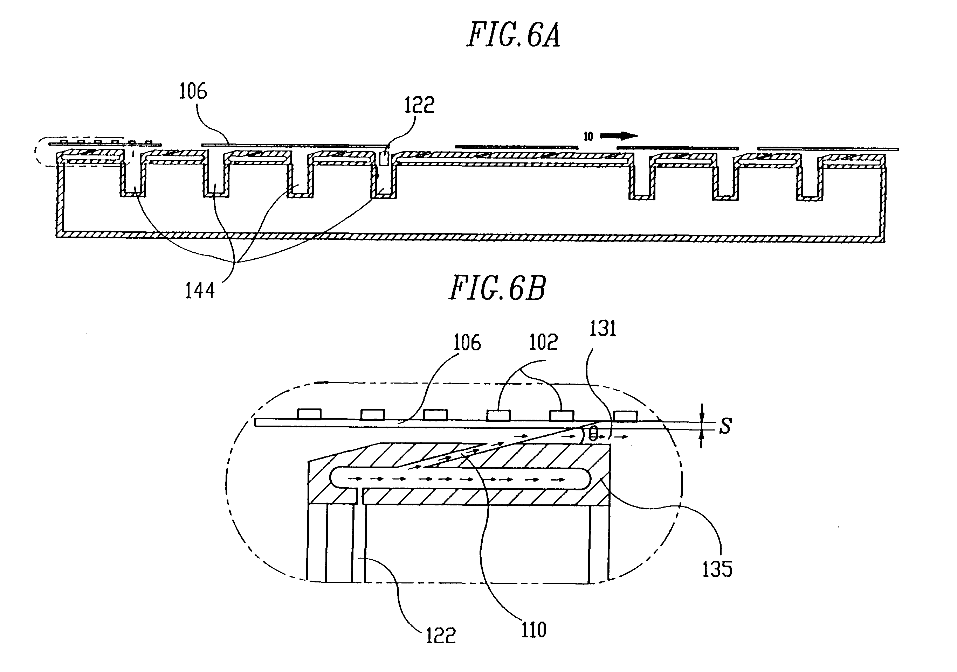

FIGs. 6A and 6B are sectional and partial enlarged views showing the steps of transporting lead frame by employing air transport system according to the present invention, respectively. Pressurized air blowed into rail through air duct (122) is vented to tilt vent holes (110) formed at an angle of θ with respect to upper surface (131) of rail (130). Then, the lead frame on vent holes (110) is forced to move along the direction of air flow. Lead frame will float on upper surface (131) of rail at the height of "S" from the surface (131). Of course, the lead frame placed between air vent holes (110) may be in contact with the upper surface (131) of rail (130), the whole lead frame is substantially floating on the rail, considering that the contact resistance of lead frame with rail is almost zero.

When the air rail transport method and apparatus described above in relation with FIGs. 5 and 6 are applied in-line system in which a die bonding apparatus is integrated with at least two wire bonding apparatuses, the whole system will be the same as that shown in FIG. 1, except lead frame transport rail, pressurized air supplying part and control part for controlling air flow.

In order to apply air rail transport techniques to in-line system, the most important parameters are the ejection angle of air with respect to the horizontal surface of lead frame strip (i.e., "θ" in FIG. 6B) and the pressure of air applied to the lead frame. According to the experiments carried out by the inventors, they are as follows:

When the air vent is formed at an angle of 90 degrees with respect to the horizontal plane, and air is supplied in the horizontal and vertical directions in order to float lead frame on rail and, while, to move lead frame, a very high air pressure (for example, about 90 - 100 liters of air/min for one wire bonding apparatus) is required. The reason such a high pressure is required is that the area of lead frame, to which pressurized air be applied, is too small. Furthermore, there may be occurred a derail of lead frame for air rail due to the loss of control.

On the other hand, when the angle of the inclination of the air vent holes is less than 90 degrees, the derailment failures of lead frame still occur until the angle reduces to about 40 degrees. At an angle of about 30 degrees, although such derailment failures can be avoided, the lead frame strip forms a wave between the parts where air is directly injected and the parts where air is not directly injected. Therefore, thin lead frame cannot be effectively transported.

When the angle is adjusted to 10 - 20 degrees, the above-described problems can be avoided and lead frame can be effectively transported. The air flow applied to one wire bonding apparatus is 30 - 60 liters/min, when the diameter of air vent is about 3 mm and the weight of lead frame is 3 - 4 grams.

When comparing the time required to deliver lead frame from the magazine ("18" in FIG. 1) of lead frame mounting stage to the magazine ("28" in FIG. 1) in the conventional conveyor belt type system and in the inventive air rail type system, it is reduced from about 4.2 seconds to about 2.4 seconds.

According to the present invention, lead frame is stopped by using plate stopper ("72" in FIG. 2) as well as vacuum stopper ("112" in FIG. 5B) in order to reduce impacts on the lead frame when the fast-moving lead frame collides with a plate stopper.

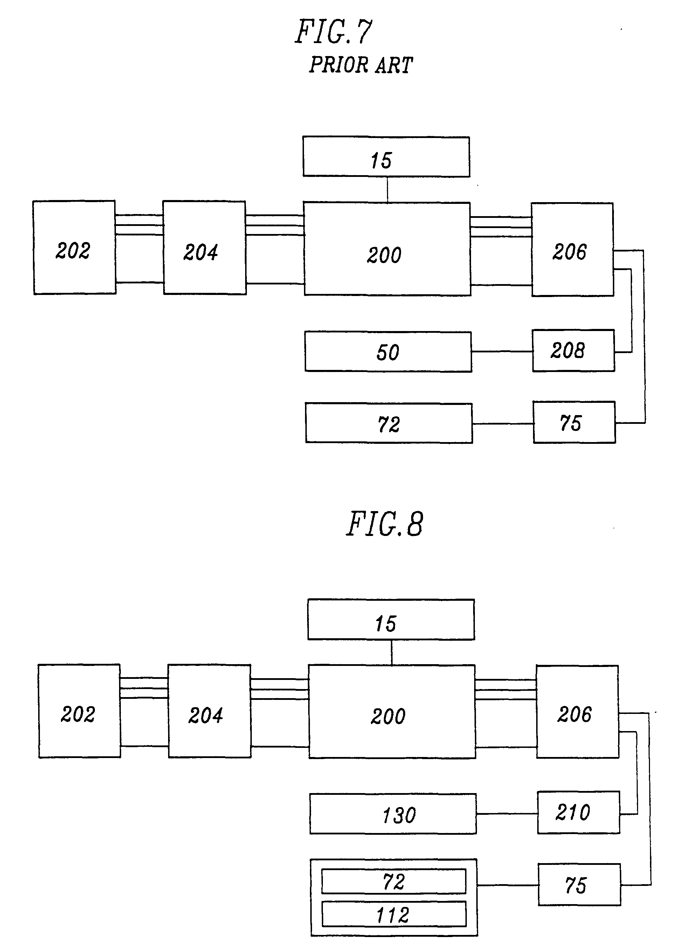

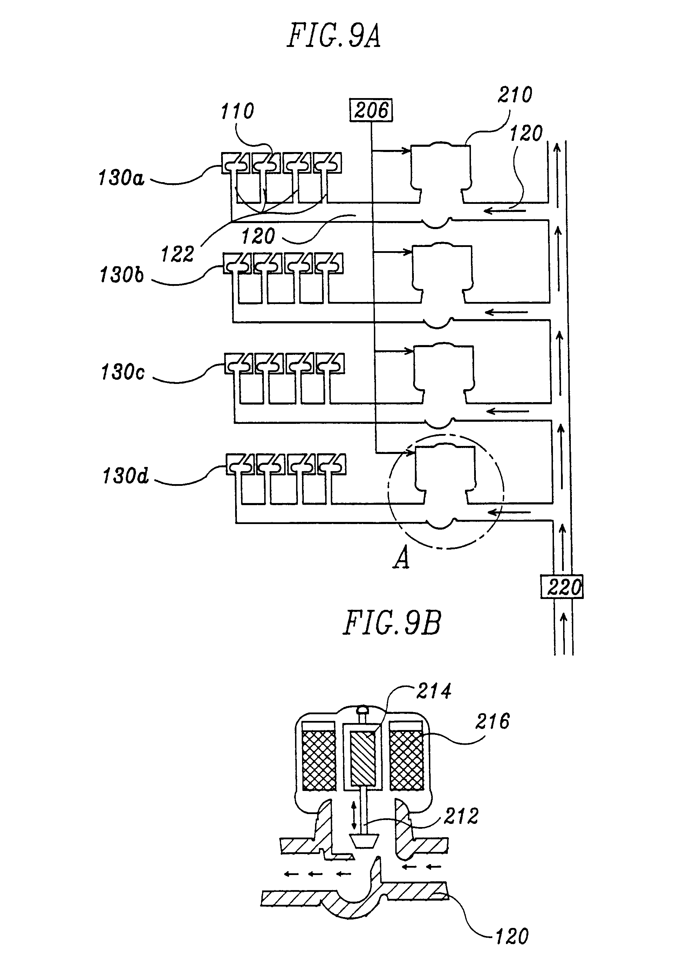

The control of the stop of lead frame at certain place by detecting the moving and arriving at the certain place of lead frame will be compared between the conventional conveyor belt type in-line system and the inventive air rail type in-line system with reference to FIGs. 7 and 8, hereinafter.

FIG. 7 is a block diagram showing the control of the moving/stop of lead frame in the conventional conveyor belt type in-line transport system. The control part (15) is a control part for controlling the operations of whole in-line system shown in FIG. 1. Sub-control part (200) receives/transmits control the signal from/to control part (15), and controls the operations of lead frame transport rail (50) and stopper (72) by receiving signals detected by sensor (202). A sub-control part (200) is provided at each wire bonding apparatus. Therefore, for example, an in-line system comprising one die bonding apparatus and four wire bonding apparatuses is provided with four sub-control parts.

Sensor (202), which is placed beneath rail (50) on which the lead frame moves (see FIG. 2A), detects the position of lead frame. The position signal is transmitted from sensor (202) to sub-control part (200) via input switch (204). Sub-control part (200) transmits the signal to control part (15) to inform the status of moving lead frame as well as to outputs a proper electrical signal to control motor driving part (208) and stopper driving part (75), via output switch (206). Then, motor driving part (75) works or stops rail (50) comprising conveyor belt depending on the signals from output switch (206). An inactive signal will be entered stopper driving part (75) when rail (50) works to move lead frame, while plate stopper (72) will be sprung out of split ("74" in FIG, 2A) formed in rail (50) via stopper driving part (75).

FIG. 8 is a block diagram showing the control of the moving/stop of lead frame in the air rail type in-line transport system according to the present invention. Sensor (202), sub-control part (200), control part (15), and input and output switches (204, 206) are the same as those of conventional system in FIG. 7. According to the present invention, however, since the power to move lead frame is originated from pressurized air, not motor, the moving/stop of lead frame is controlled by coupling output switch (206) to air rail control part (210) for controlling the flow/stop of pressurized air via air duct ("120" in FIG. 5A). Stopper driving part (75) controls stopper (72) as well as vacuum hole (or "vacuum stopper") (112) formed in air rail (130), when the stopper driving part receives a signal from output switch (206). Stopper (72) is controlled by opening/closing a vacuum passage, connected between vacuum pump and the stopper, with a solenoid controller, said vacuum passage also being connected to vacuum hole (112) of air rail (130) in order to stop lead frame as well.

FIGs. 9A and 9B are schematic and partial enlarged sectional views showing the supply of air by using solenoid controller according to one embodiment of the present invention, respectively. Solenoid controller (210) is comprised of magnetic tubular iron core (214), coil (216) wound thereon, and valve (212) within the core (214), which closes or opens air duct (120). One terminal of coil (216) is connected to output switch ("206" in FIG. 8) of sub-control part, and valve reciprocates vertically, when an electric current is sent to coil (216) via output switch (206). When valve (212) moves up, the pressurized air is sent via air duct (120) to air rail (130), and then ejected through air vent (110) to move lead frame on rail (130). When valve (212) moves downward, the supply of the pressurized water is cut off, resulting in the stop of lead frame.

In FIG. 9A, four air rails (130a, 130b, 130c, 130d) are devoted for one wire bonding apparatus. Accordingly, if the identical signals are entered coil (216) of solenoid controller (210) via output switch (206), the overall air rail (130) is simultaneously controlled. On the other hand, air rails of a wire bonding apparatus can be independently controlled by entering different signals into individual coil (216) of four solenoid controllers. The later case is advantageous when loading/unloading belt of first wire bonding apparatus works to mount lead frame into magazine while the remaining three wire bonding apparatuses work to transport lead frame on air rails.

The pressurized air blown into air duct (120) may be in-situ supplied by a controller or a separate compressor. That is to say, in FIG. 9, air supplying part (220) may be compressor or controller.

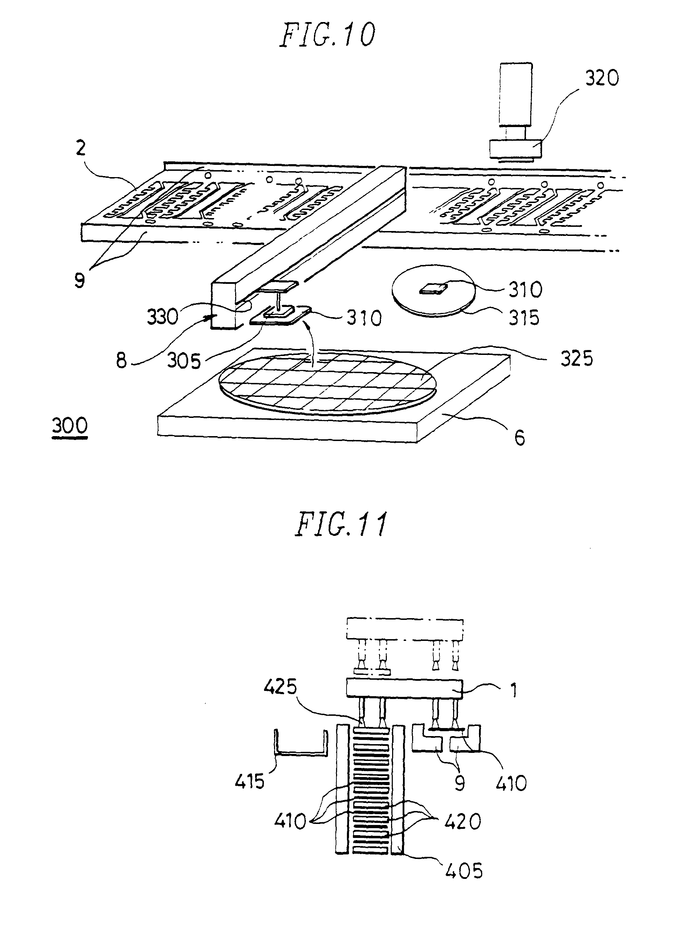

FIG. 10 is a schematic diagram of the die bonding apparatus of the in-line transport system according to the present invention. Wafer (325) is mounted onto xy-table (6) from wafer stocker ("5" in FIG. 1). Wafer (325) contains a plurality of integrated circuits and has indications of good/bad chips. The xy-table (6) can be moved along with the x- and y-axes with respect to the horizontal plane of the wafer. Chip (310) is separated from wafer (325) and moved to bonding stage (315) along with transport quirk (330) by collet (305) of chip transport part (8). Chip (310) is attached to collet (305) by action of a vacuum. When stage (315) carrying chip (310) attached thereonto is moved beneath the place where chip is attached to lead frame. Lead frame (2) is moved on rail (9) to bonding head (320). When both of lead frame (2) and chip (310), which will be subjected to chip attachment, are aligned, die bonding is conducted by bonding head (320) under heat and pressure. For the case of LOC package, chip transport part (8) moves chip (310) to stage (315) and then stage (315) moves to a position where lead frame is mounted for chip attachment. On the contrary, for the case of lead frame with die pads, chip (310) will be mounted on a die pad (not shown) of the lead frame (2) by chip transport part (8), and an adhesive, for example, Ag-epoxy adhesive is applied onto the die pad by adhesive dispenser ("3" in FIG. 1) placed beside the bonding head.

FIG. 11 is a schematic diagram showing the operation of lead frame separating apparatus, which may be employed for the die bonding apparatus in the in-line system according to the present invention. Lead frame (2) is fed to rail (9) of die bonding apparatus (300 in FIG. 10), and the feed-in speed of lead frame is controlled depending on the speed of die bonding and wire bonding. The apparatus shown in FIG. 11 is disclosed in Korean patent application No. 95-21641 filed on July 21, 1995 by the applicant. Buffering material (420), for example paper is interlaid between lead frames (410) in stocker (405) in order to prevent failures of lead frame during wire bonding process due to bending of lead frame, and one operation of the apparatus (1) makes it possible to remove the buffering material (420) and, at the same time, to pick up and transport lead frames to die bonding rail (9). Apparatus (1) picks up buffering material (420) or lead frame (410) by vacuum pad (425), and can reciprocate in vertical and horizontal directions. The simultaneous drop of lead frame (410) on rail (9) by the right vacuum pad and picking up of buffering material (420) from stocker (405) by the left vacuum pad can be accomplished by simultaneously turning off the right vacuum pad and turning on the left vacuum pad. Apparatus (1) reciprocates in vertical and then horizontal directions to feed next lead frame on rail (9). Such apparatus provided with two vacuum pads (425) makes it possible to enhance the productivity of die bonding process by increasing the speed of separating lead frame, compared with the conventional apparatus provided with one vacuum pad.

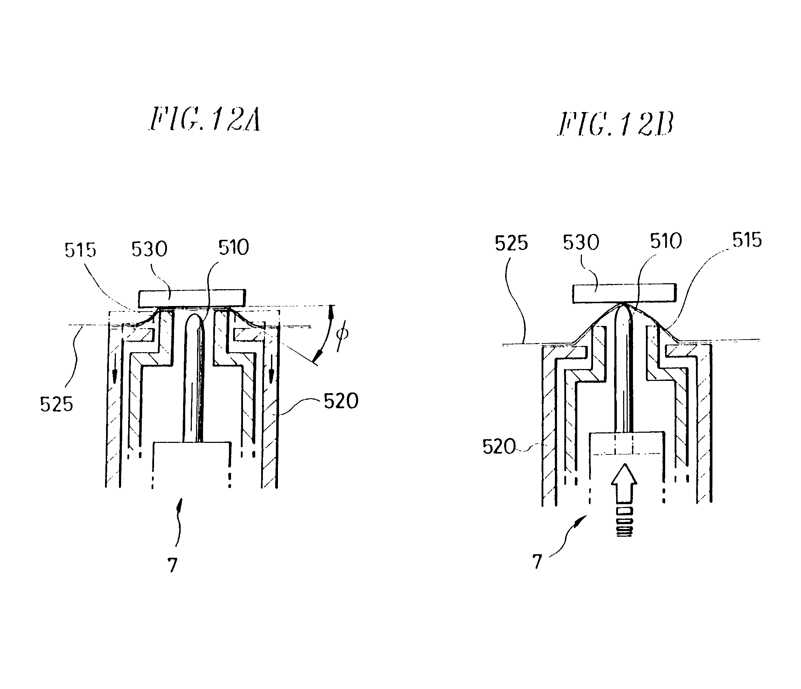

FIGs. 12A and 12B are schematic diagram showing the operation of chip separating apparatus, which may be employed in the in-line system according to the present invention. The wafer mounted on xy-table (6) of die bonding apparatus (300), shown in FIG. 10, comprises a plurality of individual chips ("dice") prepared through the steps of integrated circuit preparation, EDS (Electrical Die Sorting) and scribing, and is covered with a tape at its inactive surface. The individual chips are separated from wafer by the steps shown in FIG. 12. The apparatus shown in FIG. 12 is disclosed in Korean patent application No. 95-18136 filed on June 29, 1995 by the applicant.

With reference to FIGs. 12A and 12B, the apparatus (7) is provided with a plunge pin (510) for pushing up chip (530) attached with adhesive tape (525), ejected part (515) and cylinder (520). The apparatus (7) makes it possible to separate chip from the tape in two steps in order to prevent the formation of cracks of chip or package by the plunge pin (510).

The first separation of chip is shown in FIG. 12A. Cylinder (520) has a flat top surface in order to attain a stable mounting of chip thereon. Before the first separation, the top surface of cylinder (520), the top surface of ejected part (515) and the top of pin (510) has the same heights. Wafer should be closely fixed to the top surface of cylinder so that vacuums are formed therebetween. When cylinder (520) moves downward, wafer is inclined downward accordingly by the action of vacuum suction, except the chip in contact with the plunge pin (510) and the ejected part (515). As a result, tape (525) stuck to edges of the chip (530) is detached therefrom. The distance that the cylinder moves is preferably determined so that the angle "φ" can be within the range from 5 degrees and 10 degrees. By this, about 40-50% of the area of the tape stuck to the chip can be detached.

After that, the remaining parts of the tape adhered to chip can be entirely detached by moving upward the pin (510) as shown in FIG. 12B. Thus separated chip (530) will be transported to die bonding head by collet (305 in FIG. 10) for chip attachment. The apparatus (7) separates chip in two steps, thereby making it possible to separate chip with less force and to reduce impact on chip by plunge pin (510). Tape separated from chip by plunge pin only, without ejected part and cylinder, in one step has a clear and deep mark, suggesting that chip is also damaged. Such damage may cause a formation of crack. The larger the chip, the larger the damage or impact by the plunge pin.

Hereinabove, the method and apparatus of transporting lead frame in an in-line system wherein a die bonding apparatus is coupled with a plurality of wire bonding apparatus. However, the present invention can be applied to any process which requires a transport of lead frame on a rail, for example when wire bonded lead frame is transferred to trim/forming process, in which the molded packages as strip are trimmed to give individual packages and then formed to have a proper shape of outer leads, for example J-shaped outer leads.

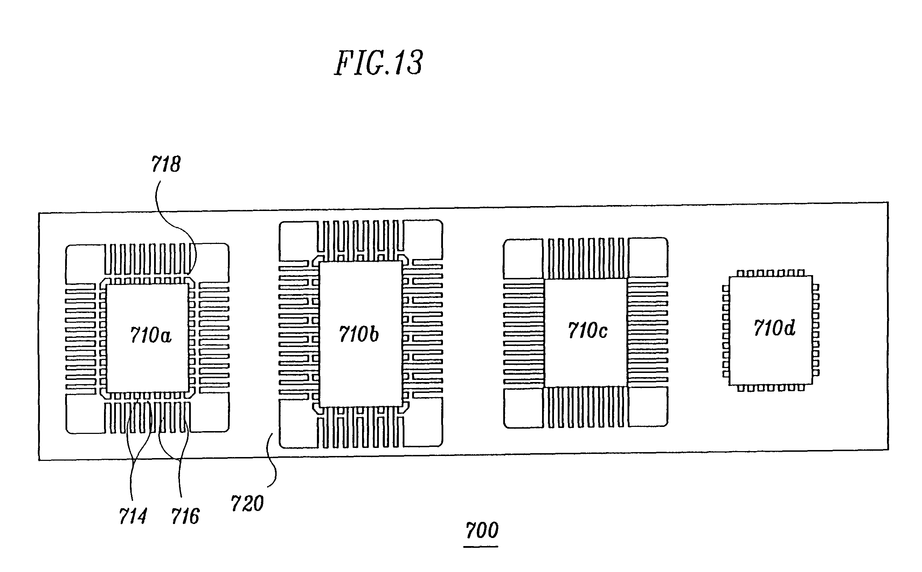

FIG. 13 is a plan view showing the progress of trim/forming from left to right sides in the drawing.

Semiconductor element (710a) is comprised of chip attached to lead frame in the form of a strip, which is encapsulated by molding process to form a package body.

The package body (710) is flushed to remove impurities from inner lead and the space between dam-bar (714) and the body (710), and outer leads (716) are surface-treated by plating tin-lead alloy by an electroplating method. Dam-bar (714) has a role to prevent an overflow of molding resins during encapsulation and tie bar (718) has a role of the supporting element during package assembly by connecting inner leads and outer leads (716) to side rail (720) of the lead frame.

Semiconductor element (710b) is in the state in which dam-bar (714) between inner lead and outer lead (716) is cut away. If all dam-bars (714) are cut away at once, the impact on leads is significant. Accordingly, alternative dam-bars are cut away.

Semiconductor element (710c) is in the state in which remaining alternative dam-bars and tie bars (718) are cut away.

The resulting package with cut dam-bars and tie bars is then subjected to forming process wherein outer leads (716) are cut and bent to have a proper shape to be adopted to a mounting board (semiconductor element 710d). The resulting package (710d) is then subjected to various tests such as burn-in tests, electrical tests, and reliability test including PCT( Pressure Cooker Test) or T/C (Temperature Cycling).

FIG. 13 is presented in order to describe merely how leads and dam-bars are trimmed/formed in the course of trim/forming process, not the real process. In fact, a lead frame strip containing 8 or 10 semiconductor elements are trimmed and then formed by using separate trimming and forming modules, or an integrated trimming/forming module.

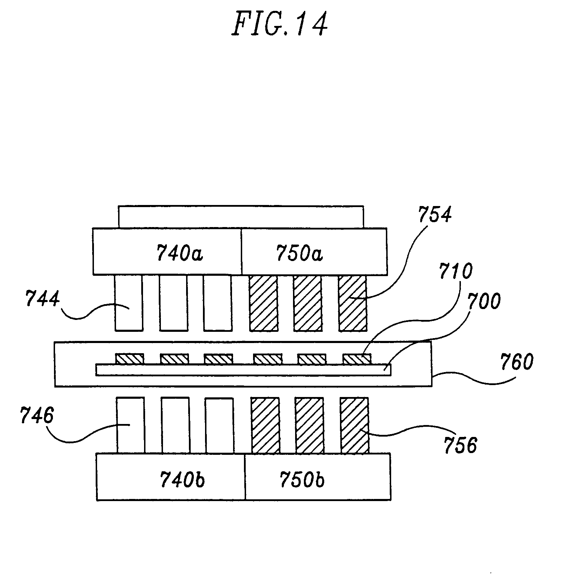

FIG. 14 is a schematic diagram of in-line trimming/forming apparatus. Trimming (740) and forming (750) apparatus is comprised of upper molds (740a, 750a), each having three trimming blades (744, 754) for cutting dam-bars, tie bars and outer leads, and lower molds (740b, 750b) for supporting semiconductor element (710) during trim/forming process. The lower molds are in contact with the element during trim/forming process. Lead frame strip (700) moves on guide rail (760). Controller (not shown) within upper mold (740a) detects the position of lead frame (700) and controls the operations of trimming (740) and forming (750) apparatus as well as the moving/stop of lead frame (700).

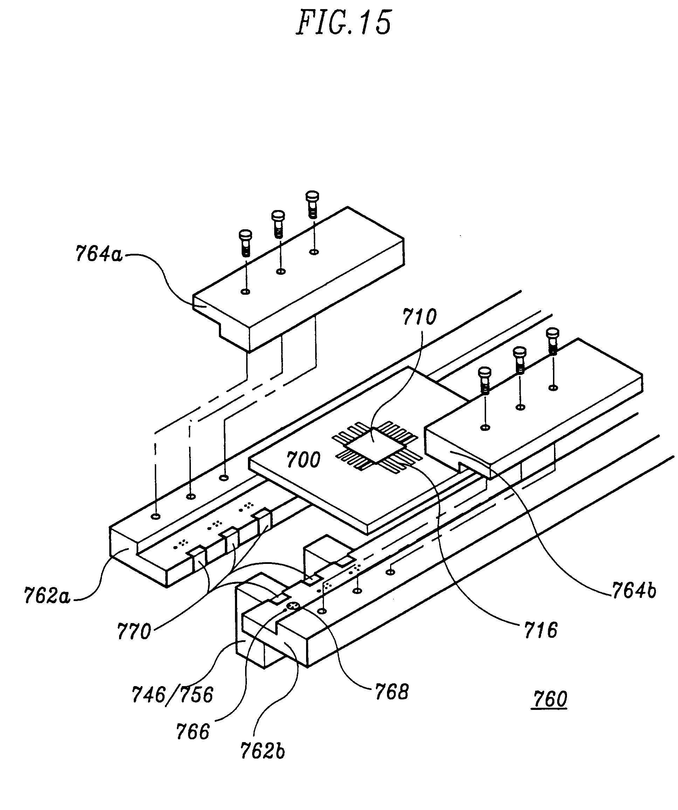

FIG. 15 is a partial perspective view of in-line trimming/forming apparatus. Guide rail (760) is comprised of air rail (762) on which lead frame strip (700) moves, and clamp (764) for holding lead frame (700) during trim/forming process. Air rail (762) is composed of two opposite spaced rails (762a, 762b). Lower mold (740b in FIG. 14) of trimming apparatus (740 in FIG. 14) or lower mold (750b in FIG. 14) of forming apparatus (750 in FIG. 14) positions at the space between rails (762a, 762b) and supports semiconductor element (710). Air rail (762) is comprised of air vent (766) for ejecting pressurized air as power for moving lead frame and vacuum hole (768) for stopping lead frame. Lead frame may be brocken by the molds, when the alignment of lead frame is not correct. Therefore, sensor (770) for detecting the position of lead frame is provided at air rail (762) for controlling the flow of the pressurized air or vacuum by transmitting the signals from sensor (770) to control part (730 In FIG. 13).

Usually, lead frame strip has index holes (not shown) in order to be used for transporting lead frame. However, such transport of lead frame cause an inevitable abrasion of parts of apparatus and a decrease in the productivity. By contrary, according to the present invention, since mechanic parts are rarely employed for transporting lead frame, problems in associated with mechanical transport, for example abrasions of parts or lead frame failures can be effectively eliminated.

Although few embodiments wherein the lead frame is transported in the in-line die bonding/wire bonding system and in the in-line trim/forming system, are described herein, it will be apparent to the ordinary skilled person in the art that the method and apparatus can be applied to other assembly stages in which lead frame should be transported.

Further, for preparation of memory modules, a printed wiring board can be transported by using pressurized air instead of conventional conveyor belts.

## Claims

1. An apparatus for transporting a lead frame (106, 700) in a manufacturing line of semiconductor chip package devices in which said lead frame (106, 700) moves along rails (130, 762), said rails (130, 762) being provided with vent holes (110, 766); said apparatus comprising an air supplying means (122) for blowing air through said vent holes (110, 766) to move said lead frame (106, 700), and **characterized in that** said apparatus further comprises a detector means (132, 202) for detecting position of the lead frame (106, 700), said detector means (132, 202) being placed on said rail (130, 762), and a stop means (75) for stopping said lead frame (106, 700) at a predetermined position are provided, said stop means (75) being placed after said detector means (132, 202) in moving direction of the lead frame (106, 700).

2. The apparatus of claim 1, **characterized by** a control means (200) for controlling said air supplying means (122) and said stop means (75).

3. The apparatus of claim 1 or 2, **characterized in that** said vent holes (110, 766) are formed at an angle ranging from about 10° to 20° with respect to a moving plane (131) of said lead frame (106, 700).

4. The apparatus according to any of claims 1 to 3, **characterized in that** said stop means (75) comprises a vacuum hole (112, 768) for applying vacuums between said rail (130, 762) and said lead frame (106, 700).

5. The apparatus according to any of claims 1 to 4, **characterized in that** said stop means (75) further comprises a stopper (72) to stop said lead frame (106, 700).

6. The apparatus according to any of claims 1 to 5, **characterized in that** said lead frame (106, 700) contains semiconductor chips (102, 310, 710) attached thereto.

7. The apparatus according to any of claims 1 to 6, **characterized in that** said lead frame (106, 700) contains semiconductor chips (102, 310, 710) attached thereto, said lead frame (106, 700) and said chips (102, 310, 710) are being electrically interconnected.

8. The apparatus according to any of claims 1 to 7, **characterized in that** said rails (130, 762) are comprised of a plurality of sub-rails (153), said sub-rails (153) being formed so that an upper edge thereof facing the lead frame (106, 700) fed into said rail (130, 762) has a slant surface.

9. An in-line apparatus comprising
(I) a die bonding means (320) for attaching semiconductor chip (102, 310) to a lead frame (2, 106) with an adhesive, said lead frame (2, 106) being comprised of leads which will be electrically connected to semiconductor elements (102, 310) and a side rail (9, 108) surrounding said leads and forms a shape of lead frame (2, 106);
(ii) a curing means (12) for curing said adhesive;
(iii) a plurality wire bonding means (20) for electrically connecting said lead frame (2, 106) to said chip (102, 310) through wires;
(iv) a buffering means (14) for control a speed of transporting said lead frame (2, 106) from said die bonding means (320) to said wire bonding means (20); and
(v) a control part (15) for controlling said in-line apparatus; said apparatus further comprising
(vi) an apparatus (100) for transporting lead frame (106, 700), which comprises
(A) rails (130, 762) on which said lead frame (106, 700) will be moved and which have vent holes (110, 766) formed at a certain angle with respect to a moving plane (131) of said lead frame (106, 700);
(B) an air supplying means (122) for blowing air through said vent holes (110, 766) to move said lead frame (106, 700);
(C) a stop means (75) for stopping said lead frame (106, 700) at a predetermined position;
(D) a detector means (132, 202) for detecting position of lead frame (106, 700), said detector means (132, 202) being placed on said rail (130, 762); and
(E) a control means (200) for controlling said air supplying means (122) and said stop means (75).

10. The apparatus of claim 9, **characterized in that** said vent holes (110, 766) are formed at an angle ranging from about 10° to 20° with respect to the moving plane (131) of said lead frame (106, 700).

11. The apparatus of claim 9 or 10, **characterized in that** said control means (E) comprises an input switch (204) connected to said control part (v) and receiving signals from said detector means (D), and an output switch (206) for transmitting control signals to said air supplying means (B), and wherein said air supplying means (B) supplies depending on said control signals from said output switch (206).

12. The apparatus according to any of claims 9 to 11, **characterized in that** said air supplying means (B) comprises
an air duct (120), through which the air passes, said air duct (120) being connected to said air vents (110, 766);
coils (216) connected to said output switch (206);
a solenoid (210) having an iron core (214) wound with said coils (216); and
a valve (212) for closing or shutting an air flow through said air duct (120) depending on magnetic fields from said solenoid (210).

13. The apparatus according to any of claims 9 to 12, **characterized in that** said stop means (C) is a vacuum hole (112, 768) for applying vacuums between said rail (130, 762) and said lead frame (106, 700).

14. The apparatus according to any of claims 9 to 13, **characterized in that** said rails (130, 762) are comprised of a plurality of sub-rails (153), said sub-rails (153) being formed so that an upper edge thereof facing the lead frame (106, 700) fed into said rail has a slant surface.

15. The apparatus according to any of claims 9 to 14, **characterized in that** said sub-rails (153) are uniformly departed from each other and have at least one air vents (110, 766).

16. The apparatus according to any of claims 9 to 15, **characterized in that** said lead frame (106, 700) substantially floats on said rails (130, 762).

17. The apparatus according to any of claims 9 to 16, **characterized in that** said die bonding means (I) comprises
a chip separating means (7) for separating individual chips (310) from a wafer (325) containing a plurality of chips;
a lead frame picking means (1) for picking up individual lead frames (410) from a stocker (405) containing a plurality of lead frames (410);
rails (9) on which said lead frames (410) are moved; and
a bonding head (320) for attaching said chip (310) to said lead frame (2) with an adhesive under pressure and heat.

18. The apparatus according to any of claims 9 to 17, **characterized in that** said lead frame stocker (405) contains a plurality of lead frames (410) together with buffering materials (420) interlaid therebetween; and
said lead frame picking means (1) comprises a first vacuum pad (425) for picking up a lead frame (410) from the stocker (405) and feeding it to the rails (9) of die bonding means (I) and a second vacuum pad (425) for picking up the buffering material (420).

19. The apparatus according to any of claims 9 to 18, **characterized in that** said chip separating means (7) separates an individual chip (310) from the wafer (325) in two steps.

20. The apparatus according to any of claims 9 to 19, **characterized in that** said lead frame transport apparatus (vi) has an inlet magazine (18) into which die bonded lead frames (2, 106) are fed from wire bonding means (20), and an outlet magazine (28, 190) into which wire bonded lead frames (156) are fed from wire bonding means (20).

21. The apparatus according to any of claims 9 to 20, **characterized in that** said wire bonding means (iii) comprises
a bonding head (22) for electrically connecting said chip (102, 310) to said lead frame (2, 106);
a loading belt (82, 140) for transporting lead frame (2, 106) from said lead frame transport apparatus (vi) to said bonding head (22) ; and
an unloading belt (140) for transporting wire bonded lead frame (106, 156) from said bonding head (22) to said lead frame transport apparatus (vi).

22. The apparatus according to any of claims 9 to 21, **characterized in that** said loading and unloading belts (82, 140) comprise a motor (80), a conveyor belt (54), which carries lead frame (2, 106) and is worked by said motor (80), and rollers (84), onto which said belt (54) is wound.

23. The apparatus according to any of claims 9 to 22, **characterized in that** said stop means (C) further comprises a plate stopper (72) which springs and collides with the lead frame (2, 106, 700) at predetermined position.

24. A method for fabricating semiconductor chips, **characterized by** steps of
(A) separating an individual chip (102, 310) from a wafer (325) containing a plurality of individual chips;
(B) attaching said chip (102, 310) to a lead frame (2, 106) with an adhesive;
(C) curing said adhesive;
(D) stacking said lead frame (2, 106) attached with said chip (102, 310) in an inlet stocker;
(E) feeding said lead frame (2, 106) on a rail (9, 130);
(F) moving said lead frame (106) to a predetermined position on the rail (130) in front of one of wire bonders by blowing a pressurized air;
(G) moving said lead frame (106) into a wire bonding stage of the one of said wire bonders by using a conveyor belt (54);
(H) electrically connecting leads of said lead frame (106) to said chip (102, 310) through wires;
(I) moving said wire bonded lead frame (106) to the rail (130) by using the conveyor belt (54) ; and
(J) transporting said wire bonded lead frame (106) on the rail (130) to an outlet stocker (405) by blowing the pressurized air,
said step (J) of transporting the wire bonded lead frame (106) on rails (130) to an outlet stocker (405) further comprising steps of detecting position of said lead frame and of stopping lead frame by applying vacuums between said lead frame (106) and said rail (130).

25. The method according to claim 24 or 25, **characterized in that** said pressurized air is blown at an angle from about 10° to 20° with respect to a moving plane (131) of the lead frame (130).

26. The method according to any of claims 24 to 26, **characterized in that** said pressurized air is blown from a plurality of vent holes (110) disposed in said rail (130).

27. The method according to any of claims 24 to 27, **characterized in that** said step of stopping lead frame further comprises a step of blocking the lead frame by using a stopper (112) when applying vacuums between said lead frame (106) and said rail (130).

28. The method according to any of claims 24 to 28, **characterized in that**, for the step (G) of moving the lead frame to wire bonding, said lead frame (106) is moved into an unoccupied one of said wire bonders by using a conveyor belt (54).

## Patentansprüche

1. Vorrichtung zum Transportieren eines Leiterrahmens (106, 700) in einer Fertigungsstraße für Halbleiterchipbausteine, in der sich der Leiterrahmen (106, 700) längs Schienen (130, 762) bewegt, wobei die Schienen mit Luftlöchern (110, 766) versehen sind; wobei die Vorrichtung Luftzufuhrmittel (122) umfaßt, die Luft durch die Luftlöcher (110, 766) blasen, um den Leiterrahmen (106, 700) zu bewegen, und **dadurch gekennzeichnet, daß** die Vorrichtung ferner Detektormittel (132, 202), die die Position des Leiterrahmens (106, 700) erfassen und auf der Schiene (130, 762) angeordnet sind, sowie Anhaltemittel (75), die dem Leiterrahmen (106, 700) an einer vorgegebenen Position anhalten, umfaßt, wobei die Anhaltemittel (75) in Bewegungsrichtung des Leiterrahmens (106, 700) hinter den Detektormitteln (132, 202) angeordnet sind.

2. Vorrichtung nach Anspruch 1, **gekennzeichnet durch** Steuermittel (200), die die Luftzufuhrmittel (122) und die Anhaltemittel (75) steuern.

3. Vorrichtung nach Anspruch 1 oder 2, **dadurch gekennzeichnet, daß** die Luftlöcher (110, 766) unter einem Winkel im Bereich von etwa 10° bis 20° in bezug auf eine Bewegungsebene (131) des Leiterrahmens (106, 700) ausgebildet sind.

4. Vorrichtung nach einem der Ansprüche 1 bis 3, **dadurch gekennzeichnet, daß** die Anhaltemittel (75) ein Unterdruckloch (112, 768) umfassen, um zwischen der Schiene (130, 762) und dem Leiterrahmen (106, 700) Unterdrücke auszuüben.

5. Vorrichtung nach einem der Ansprüche 1 bis 4, **dadurch gekennzeichnet, daß** die Anhaltemittel (75) ferner einen Anschlag (72) umfassen, um den Leiterrahmen (106, 700) anzuhalten.

6. Vorrichtung nach einem der Ansprüche 1 bis 5, **dadurch gekennzeichnet, daß** der Leiterrahmen (106, 700) Halbleiterchips (102, 310, 710) enthält, die daran befestigt sind.

7. Vorrichtung nach einem der Ansprüche 1 bis 6, **dadurch gekennzeichnet, daß** der Leiterrahmen (106, 700) Halbleiterchips (102, 310, 710) enthält, die daran befestigt sind, wobei der Leiterrahmen (106, 700) und die Chips (102, 310, 710) elektrisch miteinander verbunden sind.

8. Vorrichtung nach einem der Ansprüche 1 bis 7, **dadurch gekennzeichnet, daß** die Schienen (130, 762) mehrere Unterschienen (153) umfassen, die so ausgebildet sind, daß ihre Oberkante, die dem der Schiene (130, 762) zugeführten Leiterrahmen (106, 700) zugewandt ist, eine schräge Oberfläche besitzt.

9. Inline-Vorrichtung, die umfaßt:
(i) Chip-Bonding-Mittel (320), die einen Halbleiterchip (102, 310) an einem Leiterrahmen (2, 106) mit einem Klebstoff befestigen, wobei der Leiterrahmen (2, 106) Leitungen, die mit Halbleiterelementen (102, 310) elektrisch verbunden werden, sowie eine Seitenschiene (9, 108), die die Leitungen umgibt und eine Form des Leiterrahmens (2, 106) bildet, umfaßt;
(ii) Aushärtungsmittel (12), die den Klebstoff aushärten;
(iii) mehrere Draht-Bonding-Mittel (20), die den Leiterrahmen (2, 106) mit dem Chip (102, 310) über Drähte elektrisch verbinden;
(iv) Puffermittel (14), die die Transportgeschwindigkeit des Leiterrahmens (2, 106) von den Chip-Bonding-Mitteln (320) zu den Draht-Bonding-Mitteln (20) steuern; und
(v) einen Steuerabschnitt (15), der die Inline-Vorrichtung steuert; wobei die Vorrichtung ferner umfaßt:
(vi) eine Vorrichtung (100), die den Leiterrahmen (106, 700) transportiert und umfaßt:
(A) Schienen (130, 762), auf denen der Leiterrahmen (106, 700) bewegt wird und die Luftlöcher (110, 766) besitzen, die unter einem bestimmten Winkel in bezug auf eine Bewegungsebene (131) des Leiterrahmens (106, 700) ausgebildet sind;
(B) Luftzufuhrmittel (122), die Luft durch die Luftlöcher (110, 766) blasen, um den Leiterrahmen (106, 700) zu bewegen;
(C) Anhaltemittel (75), die den Leiterrahmen (106, 700) an einer vorgegebenen Position anhalten;
(D) Detektormittel (132, 202), die die Position des Leiterrahmens (106, 700) erfassen und auf der Schiene (130, 762) angeordnet sind; und
(E) Steuermittel (200), die die Luftzufuhrmittel (122) und die Anhaltemittel (75) steuern.

10. Vorrichtung nach Anspruch 9, **dadurch gekennzeichnet, daß** die Luftlöcher (110, 766) unter einem Winkel im Bereich von etwa 10° bis 20° in bezug auf die Bewegungsebene (131) des Leiterrahmens (106, 700) ausgebildet sind.

11. Vorrichtung nach Anspruch 9 oder 10, **dadurch gekennzeichnet, daß** die Steuermittel (E) einen Eingangsschalter (204), der mit dem Steuerabschnitt (v) verbunden ist und Signale von den Detektormitteln (D) empfängt, sowie einen Ausgangsschalter (206), der Steuersignale an die Luftzufuhrmittel (B) sendet, umfassen und wobei die Luftzufuhrmittel (B) in Abhängigkeit von den Steuersignalen vom Ausgangsschalter (206) Luft zuführen.

12. Vorrichtung nach einem der Ansprüche 9 bis 11, **dadurch gekennzeichnet, daß** die Luftzufuhrmittel (B) umfassen:
einen Luftkanal (120), durch den sich die Luft bewegt und der mit den Luftlöchern (110, 766) verbunden ist;
Spulen (216), die mit dem Ausgangsschalter (206) verbunden sind;
ein Solenoid (210), das einen Eisenkern (214) besitzt, um den die Spulen (216) gewickelt sind; und
ein Ventil (212) zum Verschließen oder Unterbrechen einer Luftströmung durch den Luftkanal (120) in Abhängigkeit von Magnetfeldern vom Solenoid (210).

13. Vorrichtung nach einem der Ansprüche 9 bis 12, **dadurch gekennzeichnet, daß** die Anhaltemittel (C) durch ein Unterdruckloch (112, 768) gebildet sind, um zwischen der Schiene (130, 762) und dem Leiterrahmen (106, 700) Unterdrücke auszuüben.

14. Vorrichtung nach einem der Ansprüche 9 bis 13, **dadurch gekennzeichnet, daß** die Schienen (130, 762) mehrere Unterschienen (153) umfassen, die so ausgebildet sind, daß ihre Oberkante, die dem der Schiene zugeführten Leiterrahmen (106, 700) zugewandt ist, eine schräge Oberfläche besitzt.

15. Vorrichtung nach einem der Ansprüche 9 bis 14, **dadurch gekennzeichnet, daß** die Unterschienen (153) gleichmäßig voneinander beabstandet sind und wenigstens ein Luftloch (110, 766) besitzen.

16. Vorrichtung nach einem der Ansprüche 9 bis 15, **dadurch gekennzeichnet, daß** der Leiterrahmen (106, 700) auf den Schienen (130, 762) im wesentlichen schwebt.

17. Vorrichtung nach einem der Ansprüche 9 bis 16, **dadurch gekennzeichnet, daß** die Chip-Bonding-Mittel (i) umfassen:
Chip-Trennmittel (700), die einzelne Chips (310) von einem mehrere Chips enthaltenden Wafer (325) trennen;
Leiterrahmen-Aufnahmemittel (1), die einzelne Leiterrahmen (410) von einer Lagereinrichtung (405), die mehrere Leiterrahmen (410) enthält, einzeln aufnehmen;
Schienen (9), auf denen die Leiterrahmen (410) bewegt werden; und
einen Bonding-Kopf (320), der den Chip (310) am Leiterrahmen (2) durch einen Klebstoff unter Druck und Wärme befestigt.

18. Vorrichtung nach einem der Ansprüche 9 bis 17, **dadurch gekennzeichnet, daß** die Leiterrahmen-Lagereinrichtung (405) mehrere Leiterrahmen (410) zusammen mit Dämpfungsmaterialien, die dazwischengelegt sind, enthält; und
die Leiterrahmen-Aufnahmemittel (1) ein erstes Unterdruckkissen (425) zum Aufnehmen eines Leiterrahmens (410) von der Lagerreinrichtung (405) und zum Befördern desselben zu den Schienen (9) der Chip-Bonding-Mittel (i) sowie ein zweites Unterdruckkissen (425) zum Aufnehmen des Dämpfungsmaterials (420) umfassen.

19. Vorrichtung nach einem der Ansprüche 9 bis 18, **dadurch gekennzeichnet, daß** die Chip-Trennmittel (7) einen einzelnen Chip (310) von dem Wafer (325) in zwei Schritten trennen.

20. Vorrichtung nach einem der Ansprüche 9 bis 19, **dadurch gekennzeichnet, daß** die Leiterrahmen-Transportvorrichtung (vi) ein Einlaßmagazin (18), dem die chipgebondeten Leiterrahmen (2, 106) von den Draht-Bonding-Mitteln (20) zugeführt werden, und ein Auslaßmagazin (28, 190), dem die drahtgebondeten Leiterrahmen (156) von den Draht-Bonding-Mitteln (20) zugeführt werden, besitzt.

21. Vorrichtung nach einem der Ansprüche 9 bis 20, **dadurch gekennzeichnet, daß** die Draht-Bonding-Mittel (iii) umfassen:
einen Bonding-Kopf (22), der den Chip (102, 310) mit dem Leiterrahmen (2, 106) elektrisch verbindet;
ein Beladungsband (82, 140), das den Leiterrahmen (2, 106) von der Leiterrahmen-Transportvorrichtung (vi) zum Bonding-Kopf (22) transportiert; und
ein Entladungsband (140), das den drahtgebondeten Leiterrahmen (106, 156) vom Bonding-Kopf (22) zu der Leiterrahmen-Transportvorrichtung (vi) transportiert.

22. Vorrichtung nach einem der Ansprüche 9 bis 21, **dadurch gekennzeichnet, daß** die Beladungs- und Entladungsbänder (82, 140) einen Motor (80), ein Förderband (54), das die Leiterrahmen (2, 106) befördert und durch den Motor (80) angetrieben wird, sowie Rollen (84), um die das Band (54) gewickelt ist, umfassen.

23. Vorrichtung nach einem der Ansprüche 9 bis 22, **dadurch gekennzeichnet, daß** die Anhaltemittel (C) ferner einen Plattenanschlag (22) umfassen, der federt und mit dem Leiterrahmen (2, 106, 700) an einer vorgegebenen Position zusammenstößt.

24. Verfahren zum Fertigen von Halbleiterchips, **gekennzeichnet durch** die folgenden Schritte:
(A) Trennen eines einzelnen Chips (102, 310) von einem Wafer (325), der mehrere einzelne Chips enthält;
(B) Befestigen des Chips (102, 310) an einem Leiterrahmen (2, 106) mit einem Klebstoff;
(C) Aushärten des Klebstoffs;
(D) Stapeln des Leiterrahmens (2, 106), an dem der Chip (102, 310) befestigt ist, in einer Einlaß-Lagereinrichtung;
(E) Befördern des Leiterrahmens (2, 106) auf einer Schiene (9, 130);
(F) Bewegen des Leiterrahmens (106) an eine vorgegebene Position auf der Schiene (130) vor einer Draht-Bonding-Einrichtung **durch** Ausblasen von Druckluft;
(G) Bewegen des Leiterrahmens (106) in eine Draht-Bonding-Stufe der Draht-Bonding-Einrichtung unter Verwendung eines Förderbandes (54);
(H) elektrisches Verbinden von Leitungen des Leiterrahmens (106) mit dem Chip (102, 310) **durch** Drähte;
(I) Bewegen des drahtgebondeten Leiterrahmens (106) zur Schiene (130) unter Verwendung des Förderbandes (54); und
(J) Transportieren des drahtgebondeten Leiterrahmens (106) auf der Schiene (130) zu einer Auslaß-Lagereinrichtung (405) **durch** Ausblasen der Druckluft,
wobei der Schritt (J) des Transportierens des drahtgebondeten Leiterrahmens (106) auf Schienen (130) zu einer Auslaß-Lagereinrichtung (405) ferner die Schritte des Erfassens der Position des Leiterrahmens und des Anhaltens des Leiterrahmens **durch** Ausüben von Unterdrücken zwischen dem Leiterrahmen (106) und der Schiene (130) umfaßt.

25. Verfahren nach Anspruch 24 oder 25, **dadurch gekennzeichnet, daß** die Druckluft unter einem Winkel von etwa 10° bis 20° in bezug auf eine Bewegungsebene (131) des Leiterrahmens (130) ausgeblasen wird.

26. Verfahren nach einem der Ansprüche 24 bis 26, **dadurch gekennzeichnet, daß** die Druckluft aus mehreren Luftlöchern (110), die in der Schiene (130) vorhanden sind, ausgeblasen wird.

27. Verfahren nach einem der Ansprüche 24 bis 27, **dadurch gekennzeichnet, daß** der Schritt des Anhaltens des Leiterrahmens ferner einen Schritt umfaßt, in dem der Leiterrahmen unter Verwendung eines Anschlags (112) blokkiert wird, wenn zwischen dem Leiterrahmen (106) und der Schiene (130) Unterdrücke ausgeübt werden.

28. Verfahren nach einem der Ansprüche 24 bis 28, **dadurch gekennzeichnet, daß** der Leiterrahmen (106) für den Schritt (G) des Bewegens des Leiterrahmens zum Draht-Bonden in eine nicht belegte der Draht-Bonding-Einrichtungen unter Verwendung eines Förderbandes (54) bewegt wird.

## Revendications

1. Dispositif destiné à transférer une structure conductrice (106, 700) sur une ligne de fabrication de dispositifs formant boîtier de pastille semi-conductrice, dans lequel ladite structure conductrice (106, 700) se déplace le long de rails (130, 762), lesdits rails (130, 762) comportant des orifices d'injection d'air (110, 766) ; ledit dispositif comprenant un moyen d'alimentation en air (122) destiné à souffler de l'air à travers lesdits orifices d'injection d'air (110, 766) afin de déplacer ladite structure conductrice (106, 700), et **caractérisé en ce que** ledit dispositif comprend, en outre, un moyen de détection (132, 202) destiné à détecter la position de la structure conductrice (106, 700), ledit moyen de détection (132, 202) étant placé sur ledit rail (130, 762), et un moyen d'arrêt (75) destiné à arrêter ladite structure conductrice (106, 700) à une position prédéterminée, ledit moyen d'arrêt (75) étant placé après ledit moyen de détection (132, 202) dans le sens du déplacement de la structure conductrice (106, 700).

2. Dispositif selon la revendication 1, **caractérisé par** un moyen de commande (200) destiné à commander ledit moyen d'alimentation en air (122) et ledit moyen d'arrêt (75).

3. Dispositif selon la revendication 1 ou 2, **caractérisé en ce que** lesdits orifices d'injection d'air (110, 766) sont formés sous un certain angle s'étendant entre 10° et 20° environ par rapport à un plan de déplacement (131) de ladite structure conductrice (106, 700).

4. Dispositif selon l'une quelconque des revendications 1 à 3, **caractérisé en ce que** ledit moyen d'arrêt (75) comprend un orifice à vide (112, 768) destiné à appliquer le vide entre ledit rail (130, 762) et ladite structure conductrice (106, 700).

5. Dispositif selon l'une quelconque des revendications 1 à 4, **caractérisé en ce que** ledit moyen d'arrêt (75) comprend, en outre, une butée (72) destinée à arrêter ladite structure conductrice (106, 700).

6. Dispositif selon l'une quelconque des revendications 1 à 5, **caractérisé en ce que** ladite structure conductrice (106, 700) contient des pastilles semi-conductrices (102, 310, 710) fixées sur celle-ci.

7. Dispositif selon l'une quelconque des revendications 1 à 6, **caractérisé en ce que** ladite structure conductrice (106, 700) contient des pastilles semi-conductrices (102, 310, 710) fixées sur celle-ci, ladite structure conductrice (106, 700) et lesdites pastilles (102, 310, 710) étant interconnectées électriquement.

8. Dispositif selon l'une quelconque des revendications 1 à 7, **caractérisé en ce que** lesdits rails (130, 762) sont constitués par une pluralité de rails secondaires (153), lesdits rails secondaires (153) étant formés de telle sorte que leur bord supérieur face à la structure conductrice (106, 700) placée sur lesdits rails (130, 762) présente une surface inclinée.

9. Dispositif de production en continu comprenant:
(i) un moyen de liaison à matrice (320) destiné à relier une pastille semi-conductrice (102, 310) à une structure conductrice (2, 106) avec un adhésif, ladite structure conductrice (2, 106) étant constituée de conducteurs, qui doivent être raccordés électriquement aux éléments semi-conducteurs (102, 310), et d'un rail latéral (9, 108) entourant lesdits conducteurs et mettant en forme la structure conductrice (2, 106) ;
(ii) un moyen d'étuvage (12) destiné à étuver ledit adhésif ;
(iii) une pluralité de moyens de soudage de conducteur (20) destinés à raccorder électriquement ladite structure conductrice (2, 106) à ladite pastille (102, 310) par l'intermédiaire de conducteurs ;
(iv) un moyen d'amortissement (14) destiné à commander une vitesse de transfert de ladite structure conductrice (2, 106) à partir dudit moyen de liaison à matrice (320), vers lesdits moyens de soudage de conducteur (20) ; et
(v) un composant de commande (15) destiné à commander ledit dispositif de production en continu ; ledit dispositif comprenant, en outre:
(vi) un dispositif (100) destiné à transférer une structure conductrice (106, 700), qui comprend:
(A) des rails (130, 762) sur lesquels ladite structure conductrice (106, 700) peut se déplacer et qui comportent des orifices d'injection d'air (110, 766) formés avec un certain angle par rapport à un plan de déplacement (131) de ladite structure conductrice (106, 700) ;
(B) un moyen d'alimentation en air (122) destiné à souffler de l'air à travers lesdits orifices d'injection d'air (110, 766) afin de déplacer ladite structure conductrice (106, 700) ;
(C) un moyen d'arrêt (75) destiné à arrêter ladite structure conductrice (106, 700) à une position prédéterminée ;
(D) un moyen de détection (132, 202) destiné à détecter la position de la structure conductrice (106, 700), ledit moyen de détection (132, 202) étant placé sur ledit rail (130, 762) ; et
(E) un moyen de commande (200) destiné à commander ledit moyen d'alimentation en air (122) et ledit moyen d'arrêt (75).

10. Dispositif selon la revendication 9, **caractérisé en ce que** lesdits orifices d'injection d'air (110, 766) sont formés suivant un certain angle s'étendant de 10° à 20° environ par rapport au plan de déplacement (131) de ladite structure conductrice (106, 700).

11. Dispositif selon la revendication 9 ou 10, **caractérisé en ce que** ledit moyen de commande (E) comprend un commutateur d'entrée (204) raccordé audit composant de commande (v) et recevant des signaux à partir dudit moyen de détection (D), et un commutateur de sortie (206) destiné à transmettre des signaux de commande audit moyen d'alimentation (B) et dans lequel ledit moyen d'alimentation en air (B) délivre de l'air en fonction desdits signaux de commande à partir dudit commutateur de sortie (206).

12. Dispositif selon l'une quelconque des revendications 9 à 11, **caractérisé en ce que** ledit moyen d'alimentation en air (B) comprend:
un conduit d'air (120), à travers lequel passe de l'air, ledit conduit d'air (120) étant raccordé auxdits orifices d'injection d'air (110, 766) ;
des bobines (216) raccordées audit commutateur de sortie (206) ;
un solénoïde (210) comprenant un noyau en fer (214) sur lequel lesdites bobines (216) sont enroulées ; et
une vanne (212) destinée à fermer ou à couper un écoulement d'air à travers ledit conduit d'air (120) en fonction de champs magnétiques générés par ledit solénoïde (210).

13. Dispositif selon l'une quelconque des revendications 9 à 12, **caractérisé en ce que** ledit moyen d'arrêt (C) est un orifice à vide (112, 768) destiné à appliquer le vide entre ledit rail (130, 762) et ladite structure conductrice (106, 700).

14. Dispositif selon l'une quelconque des revendications 9 à 13, **caractérisé en ce que** lesdits rails (130, 762) sont constitués par une pluralité de rails secondaires (153), lesdits rails secondaires (153) étant formés de telle sorte que leur bord supérieur face à la structure conductrice (106, 700) placée sur lesdits rails présente une surface inclinée.

15. Dispositif selon l'une quelconque des revendications 9 à 14, **caractérisé en ce que** lesdits rails secondaires (153) sont séparés uniformément l'un de l'autre et présentent au moins un orifice d'injection d'air (110, 766).

16. Dispositif selon l'une quelconque des revendications 9 à 15, **caractérisé en ce que** ladite structure conductrice (106, 700) flotte sensiblement sur lesdits rails (130, 762).

17. Dispositif selon l'une quelconque des revendications 9 à 16,
**caractérisé en ce que** ledit moyen de liaison à matrice (i) comprend:
un moyen de séparation de pastille (7) destiné à séparer des pastilles individuelles (310) par rapport à une tranche (325) contenant une pluralité de pastilles ;
un moyen de prélèvement de structure conductrice (1) destiné à prélever des structures conductrices individuelles (410) à partir d'un dispositif de stockage (405) contenant une pluralité de structures conductrices (410) ;
des rails (9) sur lesquels lesdites structures conductrices (410) se déplacent ; et
une tête de liaison (320) destinée à relier ladite pastille (310) à ladite structure conductrice (2) avec un adhésif sous pression et à chaud.

18. Dispositif selon l'une quelconque des revendications 9 à 17, **caractérisé en ce que** ledit dispositif de stockage de structure conductrice (405) contient une pluralité de structures conductrices (410) ensemble avec des matériaux amortisseurs (420) intercalés entre elles ; et
ledit moyen de prélèvement de structure conductrice (1) comprend un premier plot à vide (425) destiné à prélever une structure conductrice (410) à partir du dispositif de stockage (405) et à le placer sur les rails (9) du moyen de liaison à matrice (i) et un second plot à vide (425) destiné à prélever le matériau amortisseur (420).

19. Dispositif selon l'une quelconque des revendications 9 à 18, **caractérisé en ce que** ledit moyen de séparation de pastille (7) sépare une pastille individuelle (310) par rapport à la tranche (325) en deux étapes.

20. Dispositif selon l'une quelconque des revendications 9 à 19, **caractérisé en ce que** ledit dispositif de transfert de structure conductrice (vi) comporte un magasin d'entrée (18) dans lequel des structures conductrices reliées par matrice (2, 106) sont délivrées à partir du moyen de soudage de conducteur (20), et un magasin de sortie (28, 190) dans lequel les structures conductrices à conducteurs soudés (156) sont délivrées à partir du moyen de soudage de conducteur (20).

21. Dispositif selon l'une quelconque des revendications 9 à 20, **caractérisé en ce que** ledit moyen de soudage de conducteur (iii) comprend:
une tête de soudage (22) destiné à raccorder électriquement ladite pastille (102, 310) à ladite structure conductrice (2, 106) ;
une bande de chargement (82, 140) destinée à transférer la structure conductrice (2, 106) à partir dudit dispositif de transfert de structure conductrice (vi) vers ladite tête de soudage (22) ; et
une bande de déchargement (140) destinée à transférer une structure conductrice à conducteurs soudés (106, 156) à partir de ladite tête de soudage (22) vers ledit dispositif de transfert de structure conductrice (vi).

22. Dispositif selon l'une quelconque des revendications 9 à 21, **caractérisé en ce que** lesdites bandes de chargement et de déchargement (82, 140) comprennent un moteur (80), une bande de convoyeur (54) qui supporte la structure conductrice (2, 106) et est entraînée par ledit moteur (80), et des rouleaux (84) autour desquels ladite bande (54) s'enroule.

23. Dispositif selon l'une quelconque des revendications 9 à 22, **caractérisé en ce que** ledit moyen d'arrêt (C) comprend, en outre, une butée à lame (72) qui applique la structure conductrice (2, 106, 700) et la heurte à des emplacements prédéterminés.

24. Procédé de fabrication de pastilles semi-conductrices, **caractérisé par** les étapes de:
(A) séparation d'une pastille individuelle (102, 310) par rapport à une tranche (325) contenant une pluralité de pastilles individuelles ;
(B) liaison de ladite pastille (102, 310) à une structure conductrice (2, 106) avec un adhésif ;
(C) étuvage dudit adhésif ;
(D) stockage en pile de ladite structure conductrice (2, 106) reliée à ladite pastille (102, 310) dans un dispositif de stockage d'entrée ;
(E) mise en place de ladite structure conductrice (2, 106) sur un rail (9, 130) ;
(F) déplacement de ladite structure conductrice (106) vers une position prédéterminée sur le rail (130) face à l'un des dispositifs de soudage de conducteur en soufflant de l'air comprimé ;
(G) déplacement de ladite structure conductrice (106) vers un étage de soudage de conducteur de l'un desdits dispositifs de soudage en utilisant un convoyeur à bande (54) ;
(H) raccordement électrique des conducteurs de ladite structure conductrice (106) à ladite pastille (102, 310) par l'intermédiaire de conducteurs ;
(I) déplacement de ladite structure conductrice à conducteurs soudés (106) vers le rail (130) en utilisant le convoyeur à bande (54) ; et
(J) transfert de ladite structure conductrice à conducteurs soudés (106) sur le rail (130) vers un dispositif de stockage de sortie (405) en soufflant de l'air comprimé ;
ladite étape (J) de transfert de ladite structure conductrice à conducteurs soudés (106) sur des rails (130) vers un dispositif de stockage de sortie (405) comprenant, en outre, les étapes de détection de position de ladite structure conductrice et d'arrêt de la structure conductrice en appliquant le vide entre ladite structure conductrice (106) et ledit rail (130).

25. Procédé selon la revendication 24, **caractérisé en ce que** ledit air comprimé est soufflé sous un angle de 10° à 20° environ par rapport à un plan de déplacement (131) de la structure conductrice (130).

26. Procédé selon la revendication 24 ou 25, **caractérisé en ce que** ledit air comprimé est soufflé à partir d'une pluralité d'orifices d'injection d'air (110) disposés sur ledit rail (130).

27. Procédé selon l'une quelconque des revendications 24 à 26, **caractérisé en ce que** ladite étape d'arrêt de structure conductrice comprend, en outre, une étape de blocage de la structure conductrice en utilisant une butée (112) lors de l'application du vide entre ladite structure conductrice (106) et ledit rail (130).

28. Procédé selon l'une quelconque des revendications 24 à 27, **caractérisé en ce que**, pour l'étape (G) de déplacement de la structure conductrice pour le soudage de conducteur, ladite structure conductrice (106) est déplacée vers un des dispositifs de soudage de conducteur non occupé en utilisant un convoyeur à bande (54).
